# EUROPEAN PATENT APPLICATION

(11) **EP 2 862 819 A1**
(43) Date of publication of application: **22.04.2015**
(21) Application number: 13188932.1
(22) Date of filing: 16.10.2013
(51) Int. Cl.: B65G 21/10, B65G 21/06

(54) **Wafer conveyor system and method of assembling a wafer conveyor system**

(71) Applicant: APPLIED MATERIALS ITALIA S.R.L., 31048 San Biagio di Callalta (TV) (IT)
(72) Inventor: Lazzara, Simone, 31019 Portobuffolè (TV) (IT); Vazzoler, Michele, 31100 Treviso (IT); Paladin, Manuel, 31053 Pieve di Soligo (TV) (IT)
(74) Representative: Zimmermann & Partner Patentanwälte mbB

(57) **Abstract**

The present disclosure provides a conveyor system adapted for conveying a wafer to be transported. The conveyor system includes at least one roller, at least one roller bearing adapted for rotatably holding the roller, and at least one wafer transport belt spanned over the roller. When the conveyor system is assembled, i.e. when the conveyor system is in a normal operation mode, the roller bearing is held in place by the tension of the spanned wafer transport belt.

## Description

### TECHNICAL FIELD

Embodiments of the present disclosure relate to the field of wafer processing, and in particular relate to a wafer transport system. Furthermore, embodiments of the present disclosure relate to a method which facilitates assembling and disassembling of the wafer transport system. In particular, embodiments of the present disclosure are in the field of wafer transport in the solar cell production.

### BACKGROUND

In the production technology of wafer-based and thin film solar modules, handling and transport of wafers before and after carrying out processing steps are an issue. As wafer processing becomes more and more complex, sensitive to environmental conditions and cost-intensive, transporting of wafers to be processed in many cases may be performed by means of conveyor systems. These conveyor systems can be based on transport belts, e.g. driven by a motor drive means.

Such conveyor systems include the motor drive means and an arrangement for providing a belt passage. The conveyor systems can include rollers for driving the belt onto which wafers to be transported can be laid upon. During maintenance procedure, when servicing the system, or in order to exchange the belts and/or to remove the rollers, components of the conveyor system are disassembled and/or dismounted, at least partially. The disassembling and/or dismounting procedure can result in long down-times of the entire processing system, and thus in increased production costs.

In view of the above, there is a need for improvement.

### SUMMARY

In view of the above, the present disclosure provides the following.

According to an aspect, a conveyor system adapted for conveying a wafer to be transported is provided. The conveyor system includes at least one roller, at least one roller bearing adapted for rotatably holding the roller, wherein the roller bearing is held in place by the tension of the driving belt adapted for driving the roller and/or the tension of the wafer transport belt.

According to another aspect, a method for assembling a wafer conveyor system for transporting wafers is provided. The method includes providing at least one rotatably arranged roller, spanning at least one wafer transport belt or a driving belt adapted for driving the roller over the roller such that the roller is held in place exclusively by the tension of the driving belt and/or the wafer transport belt.

According to particular embodiments, the roller is held in place exclusively by the tension of the driving belt and/or the wafer transport belt.

Further embodiments, aspects, details and advantages are furthermore evident from the dependent claims, the description, and the drawings. Those skilled in the art will recognize additional features and advantages upon reading the following detailed description, and upon viewing the accompanying drawings.

### BRIEF DESCRIPTION OF THE DRAWINGS

So that the manner in which the above recited features of the present disclosure can be understood in detail, a more particular description of the disclosure, briefly summarized above, may be had by reference to embodiments. The components in the figures are not necessarily to scale, instead emphasis being placed upon illustrating the principles of the invention. Moreover, in the figures, like reference numerals designate corresponding parts. The accompanying drawings relate to embodiments of the disclosure and are described in the following:

Figure 1a illustrates a schematic side sectional view of a conveyor system, according to an embodiment;

Figure 1b illustrates a schematic side sectional view of a conveyor system, according to another embodiment;

Figure 1c illustrates a schematic side sectional view of a conveyor system, according to yet another embodiment;

Figure 2 illustrates a side view of the conveyor system, according to yet another embodiment;

Figure 3 is a detailed view of portions of the conveyor system depicted in Figure 2;

Figure 4 is an explosive view of a motor unit included in the conveyor system with two rollers attached to a common driving axis, according to another embodiment;

Figure 5 is a three dimensional view of a support unit adapted for supporting components the conveyor system, according to an embodiment;

Figure 6a illustrates details of a guide roller rotatably attachable to a guide roller axis by means of a guide roller bearing, according to an embodiment;

Figure 6b illustrates a detail of the guide roller axis shown in Figure 6a;

Figure 7 exhibits a mounting plate for fixing the guide roller bearing shown in Figure 6a; and

Figure 8 is a flowchart illustrating a method of operating a wafer conveyor system, according to an embodiment.

### DETAILED DESCRIPTION

In the following detailed description, reference is made to the accompanying drawings, which form a part hereof, and in which are shown by way of illustration specific embodiments in which the invention can be practiced. In this regard, directional terminology, such as "horizontal", "vertical" "top", "bottom", "front", "back", etc., is used with reference to the orientation of the figure(s) being described. Because components of embodiments can be positioned in a number of different orientations, the directional terminology is used for purpose of illustration and is in no way limiting. It is to be understood that other embodiments can be utilized and structural or logical changes can be made without departing from the scope of the present invention. The following detailed description, therefore, is not to be taken in a limiting sense, and the scope of the present invention is defined by the appended claims. The embodiments being described use specific language, which should not be construed as limiting the scope of the appended claims.

Reference will now be made in detail to various embodiments, one or more examples of which are illustrated in the figures. Each example is provided by way of explanation, and is not meant as a limitation of the invention. For example, features illustrated or described as part of one embodiment can be used on or in conjunction with other embodiments to yield yet a further embodiment. It is intended that the present invention includes such modifications and variations. The examples are described using specific language which should not be construed as limiting the scope of the appending claims. The drawings are not scaled and are for illustrative purposes only. For clarity, the same elements or manufacturing steps have been designated by the same references in the different drawings if not stated otherwise.

As used herein, the term "normal operation mode" should be understood as describing a mode of a conveyor system wherein the conveyor system is in an assembled state and can be used for conveying wafers to be transported. As used herein, the term "service mode" should be understood as describing a mode of a conveyor system wherein the conveyor system is disassembled and individual components of the conveyor system can be accessed and/or serviced. In the context of the present specification, the term "wafer transport direction" should be understood as a transport direction in which a wafer to be transported can be moved forth and back using a transport belt. The wafers to be transported may have dimensions in a range from 5 cm x 5 cm to 50 cm x 50 cm, and more specifically may have dimensions in a range from approximately 12 cm x 12 cm to approximately 20 cm x 20 cm such as 15.5 cm x 15.5 cm.

According to aspects, the present disclosure proposes a conveyor system adapted for conveying a wafer to be transported, wherein components of the conveyor system can be held in place by the tension of a wafer transport belt. Specifically, a conveyor system adapted for conveying a wafer to be transported can be provided. The conveyor system may include at least one roller, at least one roller bearing adapted for rotatably holding the roller, and at least one wafer transport belt spanned over the roller, wherein the roller bearing is held in place by the tension of the spanned wafer transport belt. Alternatively or additionally, the conveyor system may include at least one driving belt configured for driving the roller. The driving belt may be spanned over the roller thereby holding in place the roller.

According to embodiments described herein, the roller is held in place exclusively by the tension of the driving belt and/or the wafer transport belt. This shall be understood in that the roller is not fixed to the roller bearing in any manner, such as by screws, glue, welding, or the like.

Moreover, a method for assembling a wafer conveyor system for transporting wafers can be provided. The method may include providing at least one rotatably arranged roller, spanning at least one wafer transport belt over the roller such that the roller may be held in place by the tension of the spanned wafer transport belt, driving the wafer transport belt by means of the roller, and transporting a wafer on the driven wafer transport belt.

According to modifications thereof, the at least one rotatably arranged roller may be at least one of a driving roller adapted for driving the wafer transport belt and a guide roller adapted for guiding the wafer transport belt. Moreover, the at least one roller bearing may be at least one of a driving roller bearing adapted for rotatably holding the driving roller and a guide roller bearing adapted for rotatably holding the guide roller.

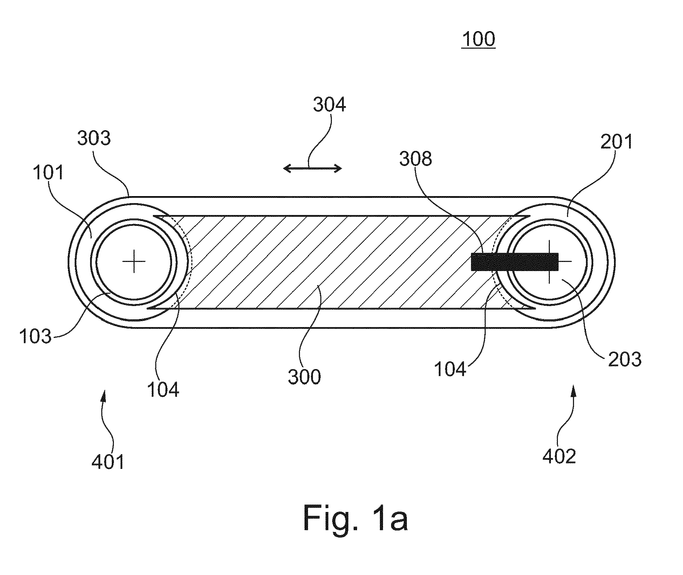

Figure 1a illustrates a conveyor system 100 according to embodiments. The conveyor system 100 includes a driving roller 101 at a first side 401, partly shown in Figure 1a, and the wafer transport belt 303 driven by the driving roller 101. Thereby, wafers to be transported can be conveyed in the wafer transport direction 304, the wafers being laid upon the wafer transport belt 303. In Figure 1a a horizontal movement of the wafer is depicted, however, the wafer to be transported can be conveyed in any direction deviating from the horizontal direction, as long as the wafer does not slip away.

An appropriate surface roughness of the belt surface can be provided such that the wafer may be fixedly held during transport. In addition to that, or alternatively, suction from below the wafer transport belt 303 provided by a suction device (not shown) can be provided such that the wafers to be transported may be safely held on the wafer transport belt 303. A support unit 300 may be provided for mounting components of the wafer transport system 100 at a processing site. The support unit 300 can include a foot portion 307 or a support frame. The foot portion 307 and/or the support frame may be designed according to requirements defined by the processing site.

At a second side 402 of the wafer transport system 100 a guide roller 201 may be provided. Thereby, wafers to be transported can be moved from one side to the other, such as from the left side 401 to the right side 402, or vice versa in the figures. By means of appropriate bearings, i.e. the driving roller bearing 103 and the guide roller bearing 203, the driving roller 101 and the guide roller 201, respectively, may be rotatably attached to the support unit 300. Thereby, at least one of a driving roller 101 adapted for driving the wafer transport belt 303 and a guide roller 201 adapted for guiding the wafer transport belt 303 is provided.

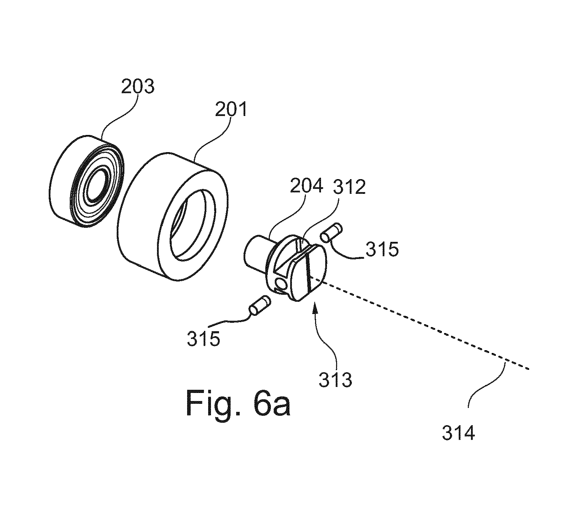

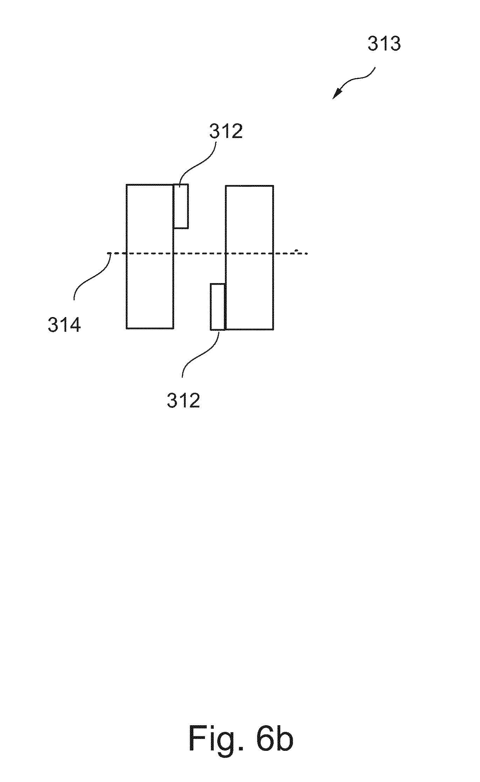

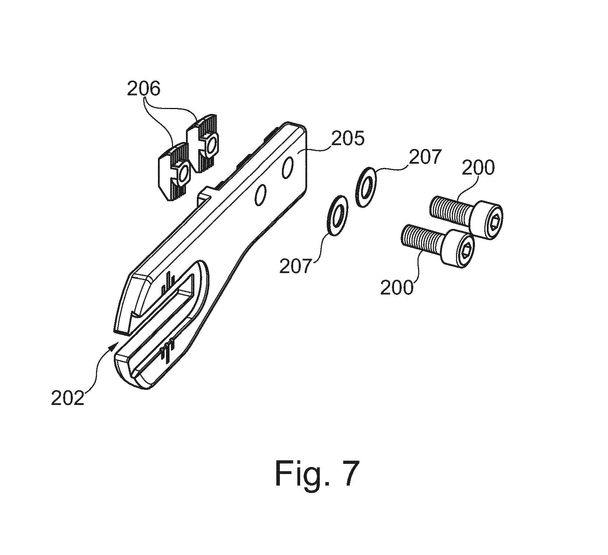

Furthermore, at least one of a driving roller bearing 103 adapted for rotatably holding the driving roller 101 and a guide roller bearing 203 adapted for rotatably holding the guide roller 201 is provided. According to an embodiment, the guide roller bearing 203 can be supported by a fixture 308 exmaples of which will be shown in more detail in Figs. 6a, 6b, and 7.

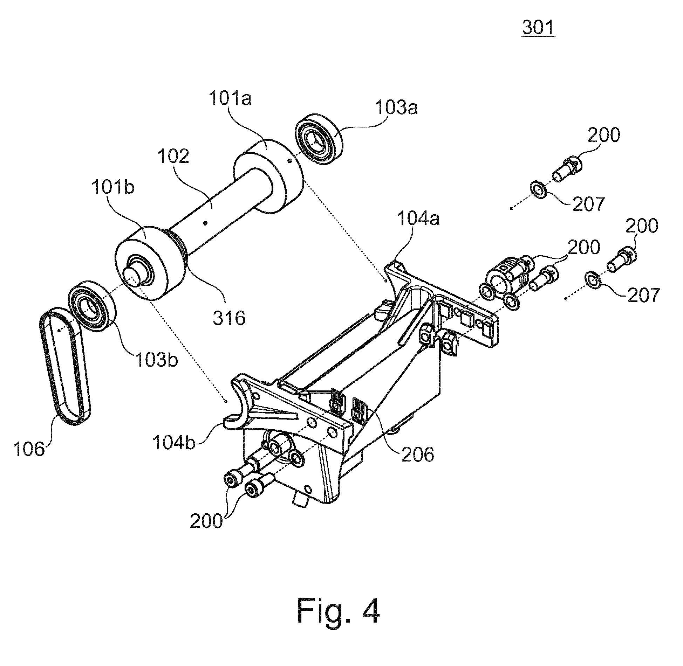

As indicated in Figure 1a, both the driving roller bearing 103 and the guide roller bearing 203 may be received in respective mounting recesses 104 provided in the support unit 300. Thereby, by loosening the wafer transport belt 303, both the driving roller bearing 103 together with the associated driving roller 101 and the guide roller bearing 203 together with the associated guide roller 201 can be released. In other words, there is typically no extra fixation of the roller provided. Thereby, a transition from the normal operation mode of the conveyor system 100 wherein the conveyor system 100 is in an assembled state and can be used for conveying wafers to be transported, to a service mode wherein the conveyor system is disassembled, can be performed in an easy and efficient manner. A release of the bearings 103, 203 from the support unit 300 is described in detail with a reference to the explosive view of Figure 4.

In other words, the conveyor system according to an embodiment which can be combined with other embodiments described herein includes at least one driving roller 101 adapted for driving the wafer transport belt 303 and at least one guide roller 201 for guiding the wafer transport belt 303.

At least one driving roller bearing 103 may be provided which may be adapted for rotatably holding the driving roller 101. In addition to that, a guide roller bearing 203 adapted for rotatably holding the guide roller 201 may be provided. The wafer transport belt 303 may be spanned over both the driving roller 101 and the guide roller 201.

According to another embodiment which can be combined with embodiments described herein, the wafer transport belt 303 can be provided as an endless belt. A material of the wafer transport belt 303 can be selected from the group consisting of rubber, plastics, polyurethane, metal, and any combinations thereof. Thereby, a material of the wafer transport belt 303 can be adapted such that the wafer transportation process can be improved.

In the normal operation mode which is depicted in Figure 1a, the driving roller bearing 103 together with the driving roller 101 and the guide roller bearing 203 together with the guide roller 201 may be held in place by the tension of the spanned wafer transport belt 303. Furthermore, in the normal operation mode, the wafer to be transported may be conveyed in an approximately horizontal direction.

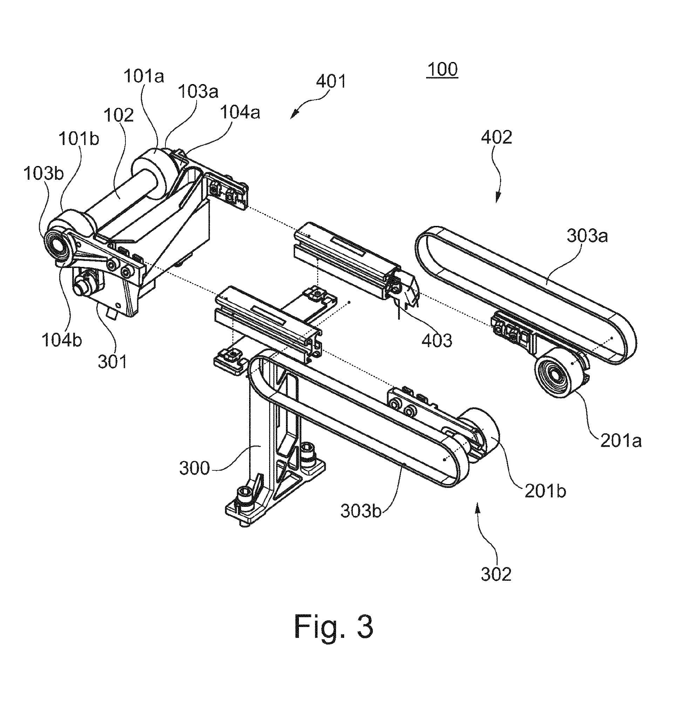

In the service mode (e.g. shown in Figure 3), the wafer transport belt 303 may be removed or at least loosened, and maintenance or service of the conveyor system 100 can be carried out by releasing at least one of the driving roller 101 and the guide roller 201, together with the associated bearings 103, 203. The wafer transport belt 303 may be removed or at least loosened, and portions of the conveyor system 100 may be replaced in case of damage of specific components, e.g. by releasing at least one of the driving roller 101 and the guide roller 201, and by optionally releasing the associated bearings 103, 203.

In the conveyor system 100 adapted for conveying a wafer to be transported, at least one driving roller bearing 103 may be provided for rotatably holding the driving roller 101, and at least one guide roller bearing 203 may be provided for rotatably holding the guide roller 201. As the wafer transport belt 303 may be spanned over the driving roller 101 and the guide roller 201, both the driving roller bearing 103 and the guide roller bearing 203 remain in the respective mounting recesses 104 by means of the belt tension.

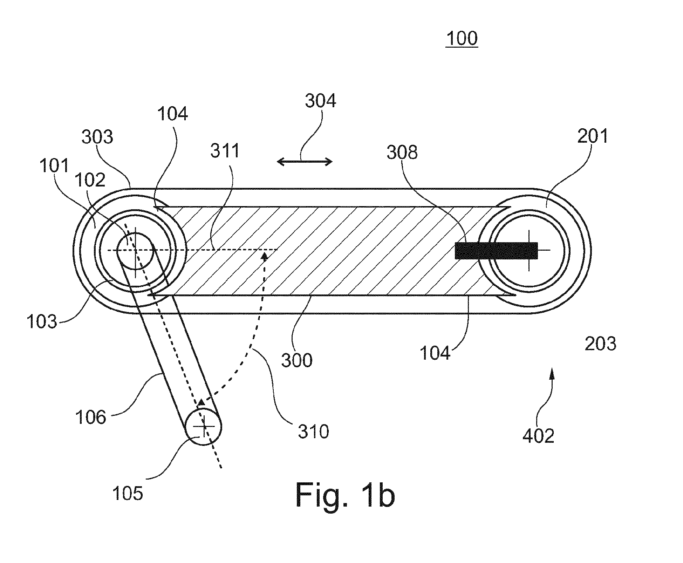

Figure 1b illustrates a schematic side sectional view of a conveyor system, according to another embodiment. As shown in Figure 1b, the driving roller 101 can be attached at a common driving axis 102, and can be driven by a driving belt 106. The driving belt 106 is spanned between the roller 101 and a motor driving roller 105, which in turn may be driven by a motor unit (not shown in Figure 1b). Using the driving belt 106, the driving roller bearing 103 together with the driving roller 101 can be held in place by the tension of the spanned driving belt 106.

In other words, the driving roller bearing 103 together with the driving roller 101 can be held in place by at least one of the tension of the wafer transport belt 303 (as has been described herein above with respect to Figure 1a), or by the tension of the driving belt 106. Furthermore, the driving roller bearing 103 together with the driving roller 101 can be held in place by the tension of the wafer transport belt 303 and the tension of the driving belt 106.

In order to provide a reliable fixture of the driving roller bearing 103 within the recess 104 by the driving belt, an angle 310 between a line connecting the axis of the driving roller bearing 103 and the axis of the motor driving roller 105, and a horizontal line 311 which is parallel to the wafer transport direction 304, is typically such that the line connecting the axis of the driving roller bearing 103 and the axis of the motor driving roller 105 touches the support unit 300. In Fig. 1b, for illustrative purposes, the largest angle is depicted with which the line connecting the axis of the driving roller bearing 103 and the axis of the motor driving roller 105 still touches the support unit 300.

The angle 310 between a line connecting the axis of the driving roller bearing 103 and the axis of the motor driving roller 105, and a horizontal line 311 which is parallel to the wafer transport direction 304 can be in a range from 0 degrees to 75 degrees, more specifically in a range from 0 degrees to 55 degrees, and even more specifically the angle 310 can amount to approximately 45 degrees. Thereby, in the service mode, by removing or at least loosening the driving belt 106, the driving roller bearing 103 and/or the driving roller 101 and/or the wafer transport belt 303 can be removed from the conveyor system 100.

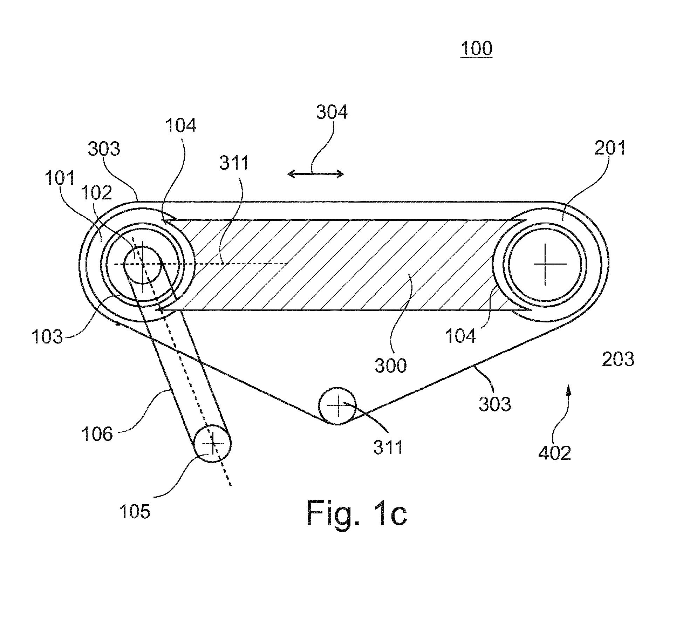

Figure 1c illustrates a schematic side sectional view of a conveyor system, according to yet another embodiment. In addition to the conveyor system setup depicted in Figure 1b, the conveyor system 100 shown in Figure 1c includes an idler roller 311 which can be used as a deflection pulley for the wafer transport belt 303. According to an embodiment which can be combined with other embodiments described herein, the wafer transport belt can be spanned by means of the idler roller 311. Furthermore, or in addition to that, the wafer transport belt 303 can be easily exchanged or serviced by moving the idler roller 311, e.g. in the direction of the support unit 300. Thereby, different lengths of wafer transport belts 303 can be compensated for by adjusting the idler roller 311 with respect to the support unit 300.

According to typical embodiments, an idler roller is provided in embodiments where the conveyor belt includes two rollers that are held in place by the transport belt and/or the driving belt. This is illustrated in Fig. 1c where also the roller 201 on the right side is not provided with a fixture.

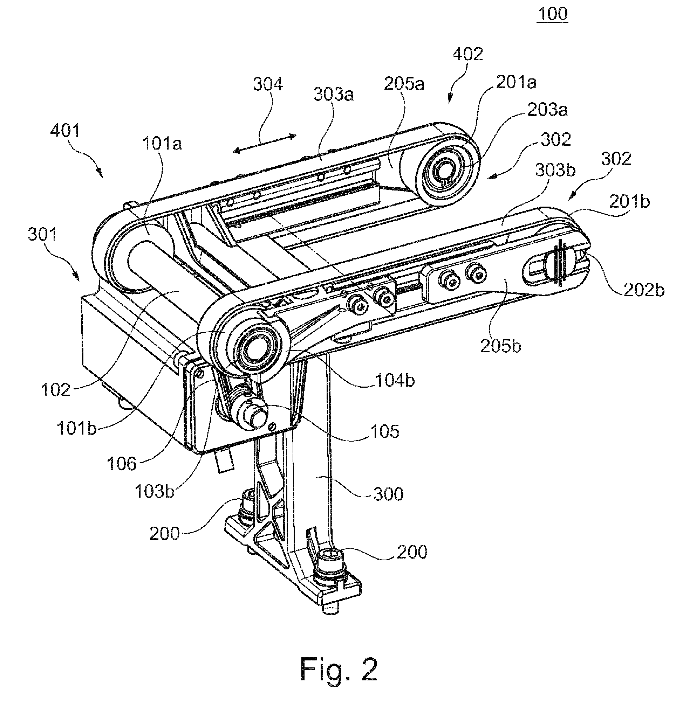

Figure 2 illustrates a side view of the conveyor system 100, according to an embodiment which can be combined with other embodiments described herein. As shown in Figure 2, a supporting unit 300 can be attached to a processing system (not shown) by means of screws 200. The support unit 300 supports the conveyor arrangement having a first side 401 with a motor unit 301 and a second side 402 with guide rollers 201a, 201b.

A termination unit at the second side 402 of the support unit can include the at least one guide roller 201a, 201b adapted for directing the associated wafer transport belts 303a, 303b back to the first side 401. Herein, the wafer transport belts 303a, 303b can be spanned in a loop between the respective driving rollers 101a, 101b at the first side 401 and the respective guide rollers 201a, 201b at the second side 402. At least one guide roller bearing 203 may be provided for rotatably holding the respective guide roller 201 at the termination unit.

In the embodiment illustrated in Figure 2, two wafer transport belts 303a, 303b may be provided for conveying wafers to be transported (not shown) in a safe and reliable manner. The two wafer transport belts 303a, 303b may be arranged approximately parallel to each other and may have a length, in the wafer transport direction 304, in a range from 10 cm to 3 m, more specifically in a range from 50 cm to 2 m, and even more specifically the length of the wafer transport belts 303a, 303b may amount to approximately 1 m. Moreover, the wafer transport belts 303a, 303b may have a width, measured perpendicular to the wafer transport direction 304, in a range from 0.3 cm to 10 cm, more specifically in a range from 0.5 cm to 2 cm, and even more specifically may have a width of approximately 1 cm.

It is noted here that only one wafer transport belt 303 or more than two wafer transport belts 303 can be used in alternative modifications of embodiments described herein. Furthermore, it is noted that Figure 2 depicts a situation where the normal operation mode has been established. A first wafer transport belt 303a may be spanned between a first driving roller 101a and a first guide roller 201a, wherein a second wafer transport belt 303b may be spanned between a second driving roller 101b and a second guide roller 201b. The two driving rollers 101a, 101b may be attached to the common driving axis 102. The driving axis 102 may be driven by the motor unit 301 by means of the motor driving roller 105. The motor driving roller 105 may be adapted for driving the common driving axis 102 by the driving belt 106. Thereby, both driving rollers 101a, 101b may be driven such that the wafer transport belt 303 can be moved in the transport direction 304, e.g. can be moved back and forth in the wafer transport direction 304.

The wafer transport belts 303a, 303b may be guided over the guide rollers 201a, 201b and back to the driving rollers 101a, 101b such that endless wafer transport belts 303 can be provided. The guide rollers 201a, 201b may be held at respective mounting plates 205a, 205b. In the mounting plates 205a, 205b mounting slots 202a and 202b, respectively, may be provided such that respective axes of the guiding rollers 201a, 201b can be moved back and forth in the wafer transport direction 304. In this way the two wafer transport belts 303a, 303b can be spanned individually. Thereby, an axis of at least one of the guide roller bearings 203a, 203b may be received in the mounting slot 202a, 202b, wherein the axis may be moveable forth and back in the wafer transport direction 304 such that the tension of the wafer transport belt 303 can be adjusted.

According to an alternative modification thereof, an axis of at least one of the driving roller bearings 103 can be received in another mounting slot (not shown in Figure 2), wherein the axis may be moveable forth and back in the wafer transport direction 304 such that the tension of the wafer transport belt 303 can be adjusted.

In the embodiment of conveyor a system 100 illustrated in Figure 2, both the driving rollers 101a, 101b and the guide rollers 201a, 201b may be rotatably attached to the support unit 300 by means of respective bearings, i.e. driving roller bearings 103a, 103b, and guide roller bearings 203a, 203b. The guide roller bearings 203a, 203b may be attached to respective mounting plates 205a, 205b, within the mounting slots 201a, 201b, at the second side 402 of the conveyor system 100.

On the other hand, the driving roller bearings 103a, 103b may be releasably held at the support unit 300 by means of the two wafer transport belts 303a, 303b, and may be received in associated mounting recesses 104a, 104b, see Figure 4. Thereby, in the service mode described herein below with respect to Figures 3 and 4, dismounting and disassembling, respectively, of the common driving axis 102 together with the two driving rollers 101a, 101b and the driving roller bearings 103a, 103 may be facilitated and service maintenance costs can be reduced. Moreover, downtime due caused by servicing procedures, or in case of damage, due to repair works, can be reduced. As can be seen from Figure 2, the wafer transport belts 303a, 303b can be removed from the conveyor system 100 in an easy and efficient manner without the requirement for dismounting any other components from the conveyor system 100.

It is noted here, although not shown in the drawings, that instead of driving the common driving axis 102 by means of the motor unit 301, one or both of the guide rollers 201a, 201b can be driven such that the wafer transport belts 303a, 303b can be moved in the wafer transport direction 304 (Figure 1a).

Figure 3 is an explosive view of main portions of a conveyor system 100 according to an embodiment which can be combined with other embodiments described herein. The conveyor system 100 is shown at least partially disassembled such that the individual components can be seen separately. It is noted here that the situation where the wafer transport belts 303a, 303b have been removed from the conveyor system 100 such that other components of the conveyor system 100 may be released as well, is denoted as the service mode in the present description.

The motor unit 301 is exemplarily shown to include the common driving axis 102 and the two driving rollers 101a, 101b attached to the driving axis 102. Furthermore, the two driving roller bearings 103a, 103b are shown which may be received in respective mounting recesses 104a, 104b. In the situation shown in Figure 3, the wafer transport belts 303a, 303b may be released such that the common driving axis 102 together with the driving rollers 101a, 101b can be disassembled, e.g. for maintenance purposes.

According to an embodiment which can be combined with other embodiments described herein, the conveyor system 100 can include a sensor unit 403 adapted for detecting a passage of a wafer being conveyed on the wafer transport belts 303a, 303b. According to yet further additional or alternative modifications the sensor unit 403 can be selected from the group including of an optical sensor, a mechanical sensor, a capacitive sensor, an ultrasonic sensor, and any combinations thereof. According to another embodiment, the sensor unit 403 may be used for movement adjustment during wafer transport.

Figure 4 is an explosive view of the motor unit 301, the motor unit 301 including the two rollers 101a, 101b shown as a unit with the common driving axis 102, and two driving roller bearings 103a, 103b provided for rotatably holding the common driving axis 102. The driving roller bearings 103a, 103b may be received, in the normal operation mode, in the mounting recesses 104a, 104b of a main block of the motor unit 301. Thereby, in the service mode, by removing the wafer transport belts 303a, 303b, the roller bearings 103a, 103b rotatably holding the respective driving rollers 101a, 101b can be released together with the associated rollers 101a, 101b.

A driving belt 106 shown on the left side of Figure 4 may be used for driving the common driving axis 102, e.g. via a driving ring 316 provided on the common driving axis 102 between the two driving rollers 101a, 101b. For assembling the motor unit 301 screws 200, washers 207 and mounting nuts 106 may be provided. According to an embodiment which can be combined with other embodiments described herein, the driving belt 106 can be provided as a toothed driving belt. According to an embodiment, the toothed drive belt can have teeth oriented in a direction approximately perpendicular to the direction of belt movement, or can have teeth oriented in a direction approximately parallel to the direction of belt movement, or can have teeth in an orientation between the perpendicular and the parallel directions. In addition to that, or alternatively, the motor driving roller 105 can be provided as a gear pinion.

According to an embodiment which can be combined with other embodiments described herein, the gear pinion can have teeth oriented in a direction approximately perpendicular to an axis of the gear pinion, or can have teeth oriented in a direction approximately parallel to the axis of the gear pinion, or can have teeth in an orientation between the perpendicular and the parallel directions. In addition to that, or alternatively, the driving ring 316 can have teeth oriented in a direction approximately perpendicular to the common driving axis 102, or can have teeth oriented in a direction approximately parallel to the common driving axis 102, or can have teeth in an orientation between the perpendicular and the parallel directions. Thereby, rotational momentum transfer from the motor unit 301 to the common driving axis 102 can be improved.

According to an embodiment which can be combined with other embodiments described herein, at least one of the driving roller bearings 103a, 103b and the guide roller bearings 203a, 203b can be selected from the group consisting of a ball bearing, a roller bearing, a conic bearing, and a groove ball bearing.

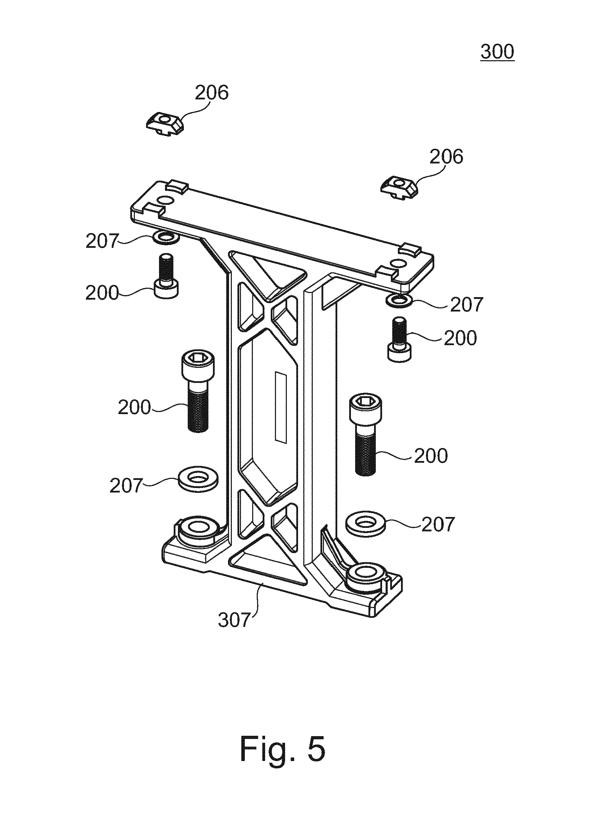

Figure 5 illustrates a foot portion 307 of the support unit 300. The foot portion 307 may be adapted to be fixed at a process site for processing wafers such that the conveyor system 100 according to an embodiment can be used for transporting wafers to be processed. The foot portion 307 can be fixed using screws 200 and washers 200. Components of the conveyor system 100 may be attached atop the foot portion 307 by means of screws 200, washers 207 and mounting nuts 206.

Figure 6a illustrates details of a guide roller 201 rotatably attachable to a guide roller axis 204 by means of a guide roller bearing 203, according to an embodiment, which can be combined with other embodiments described herein. The guide roller axis 204 may be mounted in the mounting slot 202 and can be adjusted back and forth with respect to the wafer transport direction 304, as depicted in Figure 1a. Distance elements 315 such as threaded bars may be provided and attached to the guide roller holding means 313 such that a movement of the guide roller holding means 313 in the wafer transport direction within the mounting slot (see Figure 7) can be prevented or at least reduced.

Figure 6b illustrates a detail of a guide roller holding means 313 shown in Figure 6a. As shown in Figure 6b, the guide roller holding means 313 includes protrusions 312 which can result in a tilt of the guide roller holding means 313 with respect to the center line 314 of the guide roller axis 204 in a situation where the wafer transport belt 303 is spanned. Thereby, friction between a mounting plate (see Figure 7) and the guide roller holding means 313 can fix the guide roller holding means 313 within a mounting slot (see Figure 7) of the mounting plate.

Figure 7 exhibits the mounting plate 205 for rotatably holding the guide roller bearing 203 shown in Figure 6a, by means of the guide roller holding means 313 shown in Figure 6b. As shown in Figure 7, the mounting plate 205 includes the mounting slot 202 in which the guide roller axis 204 (see Figure 6a) may be received. The mounting plate 205 may be attached, e.g. by means of screws 200, washers 207 and mounting nuts 206, to the support unit 300. The attached mounting plates 205a, 205b for each wafer transport belt 303a, 303b are illustrated in Figure 2. In other words, the guide roller holding means 313 can be adjusted in the wafer transport direction 304 using the tolerance in the mounting slot 205, whereas the guide roller holding means 313 can be fixed within the mounting slot 205using the tilt resulting from the protrusions 312 when the wafer transport belt is spanned.

Notably, the elements illustratively shown in Fig. 7 and those of Fig. 6a may constitute a fixture 308 as depicted in Fig. 1a.

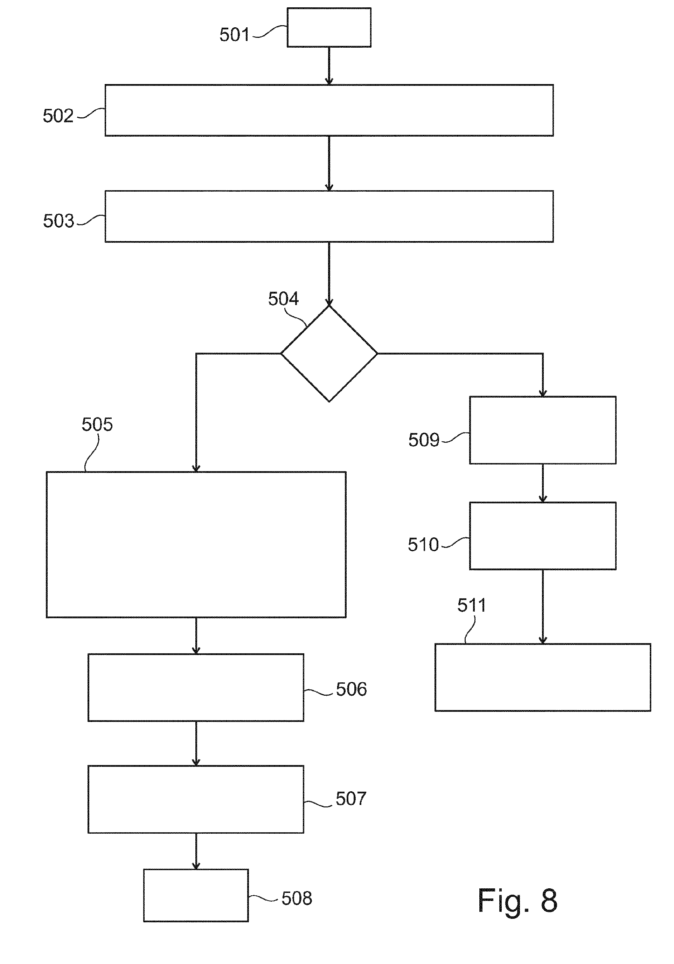

Figure 8 is a flowchart illustrating a method of operating a wafer conveyor system 100, according to an embodiment. At a block 501 the procedure may be started. Then, at least one rotatably arranged driving roller 101 (block 502) and/or at least one rotatably arranged guide roller 201 (block 503) may be provided. The procedure advances to a block 504 where it may be decided, whether or not the normal operation mode is desired. If it is determined at block 504, that the normal operation mode is desired ("yes" at block 504), then at least one wafer transport belt 303 may be spanned over the driving roller 101 and over the guide roller 201, at a block 505. Thereby, the driving roller 101 and/or the guide roller 201 may be held in place by the tension of the spanned wafer transport belt 303.

Then, at a block 506, the wafer transport belt 303 may be driven by means of the driving roller 101. At least one wafer transport belt 303 may be then driven such that a wafer can be transported on the driven wafer transport belt 303 (block 507). The procedure in normal operation mode may be ended at a block 508.

If it is determined, at the block 504, that not the normal operation mode, but the service mode is desired ("no" at block 504), then the procedure advances to a block 509, where the service mode may be started. Then, in a block 510, the wafer transport belt 303 may be removed. After removing the wafer transport belt 303, at least one of the driving roller 101 and the guide roller 201 can be released from the support unit 300. Thereby, maintenance of the conveyor system 100, or at least components of the conveyor system 100 can be provided.

According to another embodiment the conveyor system 100 can include a sensor unit 403 which can include an optical sensor, a mechanical sensor, a capacitive sensor, an ultrasonic sensor, and any combinations thereof. Using the sensor unit 403 a passage of a wafer being conveyed on the wafer transport belts 303a, 303b can be detected and/or a movement adjustment during wafer processing can be carried out. Furthermore, wafer transportation can be controlled or at least monitored.

The conveyor system 100 according to embodiments described herein can be used efficiently for transporting wafers, e.g. in the solar cell production. The described transition from normal operation mode to service mode and back allows for both simple and cost-efficient wafer transportation and conveyor system maintenance during solar cell processing.

While the foregoing is directed to embodiments of the invention, other and further embodiments of the invention can be devised without departing from the basic scope thereof, and the scope thereof is determined by the claims that follow.

## Claims

1. A conveyor system adapted for conveying a wafer to be transported on a wafer transport belt, the conveyor system comprising:
at least one roller; and,
at least one roller bearing adapted for rotatably holding the roller,
wherein the roller bearing is held in place by at least one of
the tension of a driving belt adapted for driving the roller and
a tension of the wafer transport belt.

2. The conveyor system according to claim 1, wherein the roller is held in place exclusively by at least one of the tension of the driving belt and tension of the wafer transport belt.

3. The conveyor system according to claim 1 or 2, wherein the at least one roller is at least one of a driving roller adapted for driving the wafer transport belt and a guide roller adapted for guiding the wafer transport belt, and/or wherein the at least one roller bearing is at least one of a driving roller bearing adapted for rotatably holding the driving roller and a guide roller bearing adapted for rotatably holding the guide roller.

4. The conveyor system according to any of claims 1, 2 or 3, wherein an axis of the roller bearing is received in a mounting slot, wherein the axis is moveable in a wafer transport direction such that the tension of the wafer transport belt can be adjusted.

5. The conveyor system according to any one of the claims 1 to 4, wherein two wafer transport belts are arranged in parallel, and wherein two driving rollers adapted for driving the associated wafer transport belts are arranged on a common driving axis.

6. The conveyor system according to any one of the claims 1 to 5, further comprising a motor unit adapted for driving the driving roller.

7. The conveyor system according to claim 5, wherein the driving roller bearings adapted for rotatably holding the driving rollers are arranged on the common driving axis.

8. The conveyor system according to claim 6, further comprising a motor driving roller arranged at the motor unit, the motor driving roller driving the common driving axis by means of the driving belt.

9. The conveyor system according to any of the preceding claims, wherein the driving belt is a toothed driving belt, and/or wherein the motor driving roller comprises a gear pinion.

10. The conveyor system according to claim 9, wherein the teeth of the toothed driving belt are oriented in parallel to the orientation of the belt, and/or wherein the pinions of the gear pinion are oriented in an orientation that runs around the gear pinion.

11. The conveyor system according to any one of the preceding claims, wherein the wafer transport belt comprises a material selected from the group consisting of rubber, plastics, polyurethane, metal, and any combinations thereof.

12. The conveyor system according to any one of the preceding claims, wherein at least one of the driving roller bearing and the guide roller bearing are selected from the group consisting of a ball bearing, a roller bearing, a conic bearing, and a groove ball bearing.

13. The conveyor system according to any one of the preceding claims, further comprising a sensor unit adapted for detecting a passage of a wafer being conveyed on the wafer transport belt, the sensor unit being selected from the group consisting of an optical sensor, a mechanical sensor, a capacitive sensor, an ultrasonic sensor, and any combinations thereof.

14. A method for assembling a wafer conveyor system for transporting wafers, the method comprising:
providing at least one rotatably arranged roller;
spanning at least one ofat least one wafer transport belt and a driving belt over the roller such that the roller is held in place by at least one of the tension of the wafer transport belt and the driving belt.

15. The method according to claim 14, wherein the roller is held in place exclusively by at least one of the tension of the driving belt and tension of the wafer transport belt.
